# EUROPÄISCHE PATENTSCHRIFT

(11) **EP 2 456 601 B1**
(45) Veröffentlichungstag und Bekanntmachung des Hinweises auf die Patenterteilung: **09.09.2015**
(21) Anmeldenummer: 10735291.6
(22) Anmeldetag: 22.07.2010
(51) Int. Cl.: H01L 21/67, H01L 21/673, B28D 5/00

(54) **VORRICHTUNG ZUR REINIGUNG VON SUBSTRATEN AN EINEM TRÄGER**
DEVICE FOR CLEANING SUBSTRATES ON A CARRIER
DISPOSITIF DE NETTOYAGE DE SUBSTRATS SUR UN SUPPORT

(30) Priorität: 23.07.2009 DE 102009035341
(43) Veröffentlichungstag der Anmeldung: 30.05.2012
(73) Patentinhaber: Gebr. Schmid GmbH, 72250 Freudenstadt (DE)
(72) Erfinder: HARTMANN, Christoph, 72250 Freudenstadt (DE); WORM, Sven, 72280 Dornstetten (DE)
(74) Vertreter: Renger, Florian
(86) Internationale Anmeldenummer: PCT/EP2010/060668
(87) Internationale Veröffentlichungsnummer: WO 2011/009927

(56) Entgegenhaltungen:
- EP-A1- 0 374 399
- CH-A- 280 659
- JP-A- 9 019 921
- JP-A- 9 207 126

## Beschreibung

Die Erfindung betrifft eine Vorrichtung zur Reinigung von Substraten an einem Träger.

Eine solche Reinigungsvorrichtung mit Rohren zum Reinigen ist grundsätzlich aus der Offenlegungsschrift DE 10 2009 035 343 A1 bekannt. Hier ist mindestens ein längliches Rohr vorgesehen, welches in einen Längskanal in dem Träger, an dem mehrere Substrate angebracht sind, eingeführt wird und dabei Reinigungsflüssigkeit an verschiedenen Stellen einbringt. Diese Reinigungsflüssigkeit soll über Öffnungen im unteren Bereich der Längskanäle in Zwischenräume zwischen den Substraten austreten und diese Zwischenräume dabei von Verunreinigungen säubern.

Eine Vorrichtung nach dem Oberbegriff des Anspruchs 1 ist in der Offenlegungsschrift JP 09-207126 A offenbart.

### Aufgabe und Lösung

Der Erfindung liegt die Aufgabe zugrunde, eine eingangs genannte Vorrichtung zu schaffen, mit der Probleme des Standes der Technik beseitigt werden können und die insbesondere einen sicheren und störungsfreien Betrieb gewährleistet.

Gelöst wird diese Aufgabe durch eine Vorrichtung mit den Merkmalen des Anspruchs 1 oder 9. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

In einer ersten grundsätzlichen Ausgestaltung der Erfindung ist vorgesehen, dass die Vorrichtung mehrere längliche Rohre aufweist, die parallel zueinander verlaufen und die an einer Rohrhalterung angeordnet sind sowie mit einer Flüssigkeits-Versorgung flüssigkeitsleitend verbunden sind. Beispielsweise sind es vier bis sechs Rohre. Erfindungsgemäß ist hier eine Zentrierschablone vorgesehen, die die Rohre übergreift und in deren Längsrichtung relativ zu diesen bewegbar ist. Die Zentrierschablone weist Führungen für die Rohre auf, wobei der Durchmesser dieser Führungen nur geringfügig größer ist als der Außendurchmesser der Rohre, beispielsweise 2% bis 10%. Die Zentrierschablone ist relativ bewegbar zwischen einer Ansetzposition und einer Arbeitsposition. Bei der Ansetzposition befindet sich die Zentrierschablone im Endbereich der Rohre weg von der Rohrhalterung, möglicherweise also auf genau gleicher Höhe wie die Enden der Rohre oder sogar ein Stück davor. Auf alle Fälle sollten die Rohre in den Führungen der Zentrierschablone geführt sein. In einer Arbeitsposition wiederum wird die Zentrierschablone von der Ansetzposition wegbewegt, und zwar entlang der Längsrichtung der Rohre auf die Rohrhalterung zu.

Dies bedeutet also, wenn die Vorrichtung an den Träger angesetzt wird, wobei der Träger wegen der noch an ihm befindlichen Substrate sehr sorgfältig gehandhabt werden muss, dass die Zentrierschablone in genau vorgegebener Zuordnung zu dem Träger gebracht werden kann. Dadurch befinden sich auch die in der Zentrierschablone geführten Rohre in genau vorgegebener Zuordnung zu dem Träger bzw. dessen Längskanälen. Dabei ist das Ansetzen einer solchen Zentrierschablone an den Träger, insbesondere an dessen Stirnseite mit den Längskanälen darin bzw. deren Zugangsöffnungen, erheblich leichter als das Ansetzen von mehreren Rohren.

In weiterer Ausgestaltung der Erfindung kann die Zentrierschablone auch abstehende Zentriervorsprünge odgl. aufweisen. Diese können zusätzlich dazu dienen, in genau vorgegebener Zuordnung an dem Träger bzw. der zur Zentrierschablone weisenden Stirnseite anzugreifen. Dafür können in dem Träger passende Ausnehmungen odgl. für die Zentriervorsprünge vorgesehen sein. Für solche Zentriervorsprünge ist es wichtig, dass sie über die Enden der Rohre überstehen, dass also auf alle Fälle zuerst die Zentriervorsprünge und möglichst die gesamte Zentrierschablone an dem Träger anliegt bzw. in genau vorgegebener und passender Zuordnung zu diesem liegt. Dann sind nämlich die in der Zentrierschablone geführten Rohre mit den Längskanälen im Träger ausgerichtet und können danach in diese eingeführt werden.

In weiterer vorteilhafter Ausgestaltung der Erfindung ist vorgesehen, dass sämtliche Rohre einer Rohrhalterung, die also von einer Richtung in den Träger einfahren, von einer einzigen Zentrierschablone geführt werden. Diese reicht auch aus, da, sobald die Rohre in den Längskanal eingefahren sind, ein falsches Ansetzen nicht mehr möglich ist und sie somit nicht mehr geführt werden müssen.

Damit die Zentrierschablone beim Ansetzen der Rohre an den Träger stets vor den Rohren am Träger anliegt und somit die Zentrierwirkung und Führungswirkung erreicht, kann sie entweder von Hand oder mechanisch stets in die Ansetzposition gebracht werden, auch wenn sie nicht an einem Träger anliegt. Der Einfachheit halber wird dies jedoch derart automatisiert, dass eine elastische Kraft oder Federkraft die Zentrierschablone von der Rohrhalterung weg in ihre Ansetzposition bewegt. Dazu wird nachfolgend noch mehr ausgeführt.

In nochmals weiterer vorteilhafter Ausgestaltung der Erfindung kann vorgesehen sein, dass die Zentrierschablone ausschließlich auf den Rohren sitzt bzw. auf diesen geführt ist. Dies ermöglicht eine sehr einfache Konstruktion.

In alternativer Ausgestaltung der Erfindung kann mindestens ein Längsträger an der Rohrhalterung vorgesehen sein, wobei die Zentrierschablone an diesem Längsträger geführt und daran längsverschiebbar gelagert ist. Vorteilhaft sind es zwei Längsträger. Ein Längsträger sollte außerhalb der Rohre und seitlich davon verlaufen, insbesondere sollte er an dem Träger vorbeiführen, wenn die Rohrhalterung samt Rohren nahe an den Träger herangefahren wird. Hier kann eine Zentrierschablone dann sozusagen zwischen zwei Längsträgern wie zwischen zwei Schienen odgl. entlang fahren beim Einfahren der Rohre in die Längskanäle.

In nochmaliger alternativer Ausgestaltung der Erfindung kann die Zentrierschablone selbst fest mit einem Führungsstab verbunden sein, also nicht verschiebbar an diesem angeordnet sein. Dieser Führungsstab wiederum ist dann an oder in der Rohrhalterung längsverschiebbar beweglich geführt, und zwar in Längsrichtung der Rohre. Ein solcher Führungsstab muss nicht seitlich außerhalb des Trägers vorgesehen sein, da er ja in die andere Richtung von ihm weg bewegt wird. Vorteilhaft sind hier, ähnlich wie zuvor für den Längsträger beschrieben, zwei solche Führungsstäbe für eine sichere und präzises Lagerung der Zentrierschablone vorgesehen. Bei einer derartigen Ausgestaltung mit mindestens einem Führungsstab ist es auch möglich, dass eine elastische Federeinrichtung zum Bewegen der Zentrierschablone auf der von den Rohren abgewandten Seite der Rohrhalterung vorgesehen ist. Dort kann sie an ein Ende des Führungsstabes angreifen sowie an der Rohrhalterung selbst. Diese Federeinrichtung versucht dann, das Ende des Führungsstabes möglichst nahe an die Rohrhalterung zu ziehen, sie arbeitet also als Zugfeder. Vorbeschriebene Federn, insbesondere bei einer Ausgestaltung mit den Längsträgern, sind üblicherweise Druckfedern. Diese drücken die Zentrierschablone dann wieder von der Rohrhalterung weg auf den Träger zu bzw. in die Ansetzposition.

In einer anderen zweiten grundsätzlichen Ausgestaltung der Erfindung ist ebenfalls eine Zentrierschablone vorgesehen zum Übergreifen der Rohre zum Einführen in die Längskanäle des Trägers, wobei die Zentrierschablone Führungen bzw. Führungsöffnungen für die Rohre aufweist. Sie ist relativ bewegbar zwischen einer Ansetzposition im Endbereich der Rohre weg von der Rohrhalterung und einer Parkposition außerhalb der Rohre und entfernt davon, in der sie die Rohre nicht stört, wenn diese im Träger sind. Bevorzugt ist die Parkposition oberhalb der Rohre.

Vorteilhaft ist die Zentrierschablone separat von den Rohren ausgebildet und gelagert. Sie kann aber an einem gleichen Trägerrahmen odgl. befestigt sein.

In Ausgestaltung der Erfindung ist die Zentrierschablone unabhängig von den Rohren zwischen der Ansetzposition und der Parkposition bewegbar. Sie kann dazu eine eigene Verfahreinrichtung odgl. aufweisen, vorteilhaft als Linearantrieb. Vorteilhaft ist die Bewegung zwischen der Ansetzposition und der Parkposition eine lineare Bewegung, insbesondere in Richtung senkrecht zu der Längsrichtung der Rohre bzw. einer Fläche, in der die Rohre laufen.

Vorteilhaft ist die Zentrierschablone mit einer Verfahreinrichtung zum Bewegen zwischen der Park- und der Ansatzposition an einem vorgenannten Trägerrahmen angeordnet, an dem auch die Rohrhalterung mit den Rohren angeordnet ist. So kann ein gemeinsames Verschwenken erleichtert werden und die Position zueinander ist genau.

In Ausgestaltung der Erfindung sind die Führungen der Zentrierschablonen nach unten offen als Führungsöffnungen zum Übergreifen der Rohre. Es sind Arretierungsmittel am unteren Bereich der Führungen vorgesehen, die derart ausgebildet sind, dass sie die Rohre in den Führungen halten. Dies kann insbesondere durch zumindest teilweises Verschließen der Führungen unterhalb der übergriffenen Rohre erfolgen, wozu die Arretierungsmittel vorteilhaft linear verfahrbar sind. In vorteilhafter Ausgestaltung können die Arretierungsmittel sämtlicher Führungen miteinander verbunden sein zum gleichzeitigen Bewegen aller Arretierungsmittel. Dies kann insbesondere durch einen Aktor gesteuert werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: einen seitlichen Schnitt durch eine erste erfindungsgemäße Vorrichtung, in die ein Träger mit Substraten daran eingefahren ist, wobei Rohre in Längskanäle im Träger eingreifen,
- Fig. 2: eine Draufsicht auf die Darstellung aus Fig. 1 in einem Zustand, kurz bevor die Rohre in den Innenkanal des Träger einfahren,
- Fig. 3: eine Darstellung ähnlich Fig. 2, wenn die Rohre ein Stück in die Längskanäle des Trägers hineingefahren sind,
- Fig. 4: eine Draufsicht auf eine zweite erfindungsgemäße Vorrichtung mit Rohrhalterung und einer Zentrierschablone oberhalb der Rohre und
- Fig. 5: die Darstellung aus Fig. 4, bei der die Zentrierschablone auf die Rohre gefahren ist und Führungen für die Rohre verschlossen sind.

### Detaillierte Beschreibung der Ausführungsbeispiele

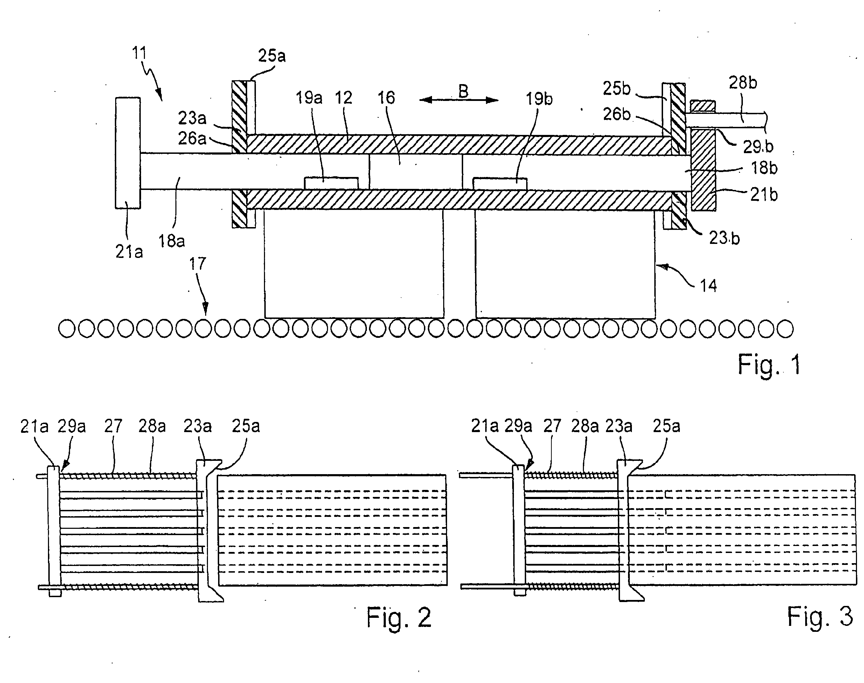

In Fig. 1 ist in einer seitlichen Schnittdarstellung eine erste Ausführung einer erfindungsgemäßen Vorrichtung 11 dargestellt, in welche ein Träger 12 eingefahren ist, an dessen Unterseite eine Vielzahl von Substraten 14 hängt. Innerhalb des Trägers 12 verlaufen mehrere Längskanäle 16 parallel zueinander. Durch das Zersägen von Siliziumblöcken in die Substrate 14 wird der Träger 12 von der Unterseite her angesägt und es entstehen Öffnungen, die die Längskanäle 16 mit Zwischenräumen zwischen den Substraten 14 verbinden. Ein solcher Träger ist aus der deutschen Patentanmeldung DE 10 2009 023 121 A1 bekannt, wobei diesbezüglich explizit auf diese Patentanmeldung verwiesen wird bezüglich Aufbau und Gestaltung des Trägers selbst. Bezüglich des Prinzips des Einbringens von Reinigungsflüssigkeit zur Reinigung der Zwischenräume zwischen den Substraten 14 wird auf die vorgenannte DE 10 2009 035 343 A1 verwiesen.

In die Längskanäle 16 sind linke Rohre 18a eingefahren, in deren Endbereich Öffnungen 19a nach unten vorgesehen sind. Die linken Rohre 18a sind an einer Rohrhalterung 21 a befestigt, welche wiederum bewegbar ist, um eben die Rohre 18a in den Längskanälen 16 einzubringen.

Im rechten Bereich der Fig. 1 greifen rechte Rohre 18b mit Öffnungen 19b nahe dem Endbereich in die Längskanäle 16. Auch die rechten Rohre 18b sind an einer Rohrhalterung 21 b befestigt und haben darüber auch einen Flüssigkeitsanschluss. Es kann also über die Rohrhalterungen 21a und 21b Reinigungsflüssigkeit in die Rohre 18a und 18b eingeleitet werden. Aus den Öffnungen 19a und 19b treten sie dann aus nach unten zwischen die Substrate 14 zum Reinigen.

Wie vor allem aus Fig. 2 und 3 deutlich wird, ist es wichtig, dass in einer Relativbewegung entsprechend der Bewegungsrichtung B des Trägers 12 in der Vorrichtung 11 sämtliche Rohre 18a, 18b genau in die Längskanäle 16 hineingeführt werden. Damit dieses angesichts der Länge der Rohre 18a, 18b in der Praxis, die bei 40 cm bis 100 cm liegen kann, und einem geringen Durchmesser von wenigen Millimetern stets exakt und zielgenau passt sind erfindungsgemäß Zentrierschablonen 23a und 23b für jeweils die linken Rohre 18a und die rechten Rohre 18b vorgesehen. Diese Zentrierschablonen 23a und 23b weisen jeweils Zentriervorsprünge 25a und 25b auf, die gemäß Fig. 2 noch vor den Rohren 18a, 18b an dem Träger 12 anliegen. Dabei ist zu erkennen, dass so die Zentrierschablone 23a in ihrer Ansetzposition ist und somit vor den Rohren 18a mit dem Träger 12 in Kontakt kommt.

Die Rohre 18a und 18b laufen in Öffnungen 26a und 26b in den Zentrierschablonen 23a und 23b. Mittels der Zentriervorsprünge 25a und 25b, die selbstzentrierend ausgebildet sind in Verbindung mit dem Träger 12, kommen die Zentrierschablonen 23a, 23b in genau vorgegebener Position an den Träger 12 von beiden Seiten heran. Durch die genaue Führung der Rohre 18a, 18b in den Zentrierschablonen 23a, 23b mittels der Öffnungen 26a, 26b ist dann wiederum leicht sichergestellt, dass die Rohre 18a, 18b eben auch genau in die Längskanäle 16 treffen beim Bewegen des Trägers 12 relativ zu den Rohrhalterungen 21a, 21b.

Bei dieser Relativbewegung wiederum verbleibt die jeweilige Zentrierschablone 23a, 23b an der Stirnseite des Trägers 12, wozu eine Feder 27 vorgesehen ist. Diese ist hier schematisch eingezeichnet als Druckfeder zwischen Zentrierschablone 23a, 23b und Rohrhalterung 21 a, 21 b. Die Feder 27 stellt sicher, dass die jeweilige Zentrierschablone 23a, 23b bei Entfernen der Rohre 18a, 18b aus dem Träger 12 bzw. dessen Längskanälen 16 wieder an das Ende der Rohre 18a, 18b bewegt wird, also wieder in die Ansetzposition. In dieser Ansetzposition ist nämlich wiederum sichergestellt, dass zuerst die Zentrierschablone 23a, 23b mit dem Träger 12 in Berührung kommt und sich mittels der Zentriervorsprünge 25a, 25b daran ausrichten kann. Alternativ zu der Druckfeder 27 könnte gemäß Fig. 2 auch eine Zugfeder vorhanden sein zwischen einem der linken Enden der Führungen 29 mit der Rohrhalterung 21a, 21 b.

Einerseits ist es zwar grundsätzlich möglich, dass die Rohre 18a, 18b selbst die Zentrierschablone 23a, 23b bzw. deren Gewicht tragen. Angesichts der vorgenannten Länge der Rohre 18a, 18b wäre dies selbst bei einer leichten Zentrierschablone 23a, 23b eine unnötig große Belastung. Deswegen ist vorteilhaft gemäß der Fig. 2 und 3 vorgesehen, dass die jeweilige Zentrierschablone 23a, 23b zwei Führungsstangen 28a, 28b aufweist, die in Führungen 29a in der Rohrhalterung 21 a verlaufen. Zwar benötigt die jeweilige Zentrierschablone 23a, 23b eine gewisse Bewegbarkeit in einer Ebene senkrecht zur Bewegungsrichtung B, um sich eben an den herannahenden Träger 12 anpassen bzw. daran ausrichten zu können. Insofern sollten die Führungsstangen 28a, 28b in den Führungen 29a, 29b der Rohrhalterung 21a, 21 b ein gewisses Spiel haben. Ein Spiel der Rohre 18a, 18b in der Zentrierschablone 23a, 23b bzw. deren Öffnung 26a, 26b wiederum sollte sehr gering sein, da die Zentrierschablone 23a, 23b ja exakt die Rohre 18a, 18b in die Längskanäle 16 einführen soll.

In Abwandlung der Zentrierschablone 23a, 23b ist es auch leicht vorstellbar, dass die Zentriervorsprünge 25a, 25b nicht seitlich außen den Träger 12 übergreifen und sich daran zentrieren, sondern in weitere Öffnungen odgl. des Trägers 12 hineinfahren. Ebenso können auch auf der Oberseite des Trägers 12 bestimmte Konturen vorgesehen sein, die eine sichere Festlegung der Zentrierschablone daran ermöglichen.

Der Träger 12 mit den Substraten 14 läuft auf einer schematisch dargestellten Rollenbahn 17. In der Praxis laufen natürlich nicht die Substrate 14 selbst darauf, sondern Träger 12 und Substrate 14 sind in einer käfigartigen Trägervorrichtung eingespannt, die allerdings aus dem Stand der Technik bekannt ist, welche dann wiederum auf der Rollenbahn 17 läuft.

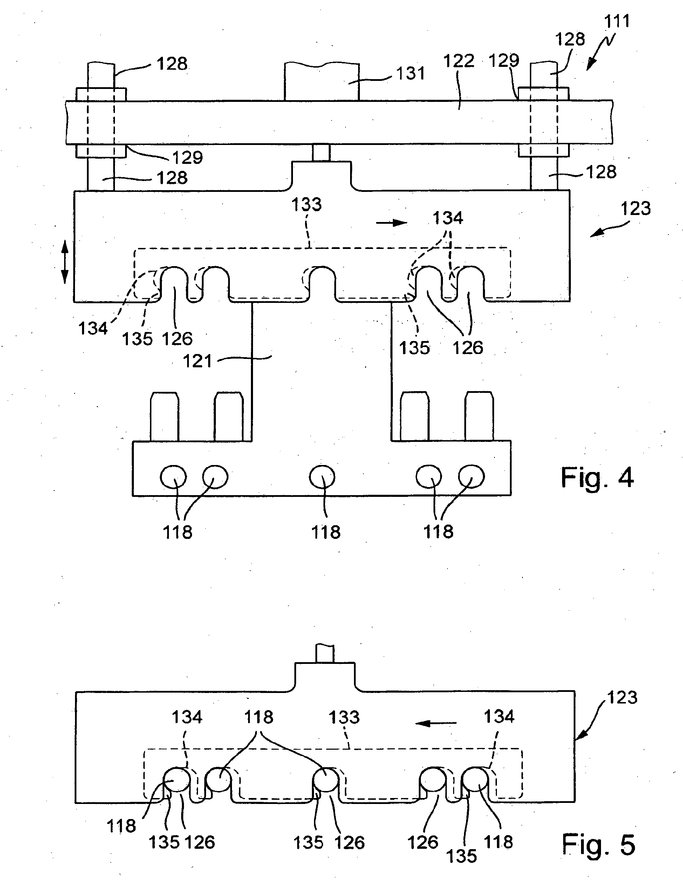

Eine zweite alternative Ausführung einer erfindungsgemäßen Vorrichtung ist in den Fig. 4 und 5 dargestellt, und zwar in der Vorderansicht entlang der Längsrichtung von Rohren 118, die sozusagen aus der Zeichenebene herausstehen. Diese Rohre 118 sind an einer Rohrhalterung 121 befestigt ähnlich Fig. 3. Die Rohrhalterung 121 wiederum ist auf nicht dargestellter Art und Weise mittels eines Schwenkarms 122, der beispielsweise nach rechts weitergeht, um eine Schwenkachse parallel zu den Rohren 118 schwenkbar. Ein solcher Schwenkarm kann im übrigen auch bei den Ausführungen der Fig. 1 bis 3 vorgesehen sein. So können die Rohre 118 samt Rohrhalterung 121 wie eingangs beschrieben zuerst aus dem Bewegungsweg eines Trägers gebracht werden und dann wieder hinein bewegt werden zum Auffahren des Trägers auf die Rohre 118 bzw. um die Rohre 118 in den Träger hinein zu bringen.

An dem Schwenkarm 122 ist auch eine Zentrierschablone 123 angeordnet, und zwar über zwei Führungsstangen 128, die an ihrer Oberseite befestigt sind. Diese Führungsstangen 128 laufen in Führungen 129 am Schwenkarm 122. Bewegt wird die Zentrierschablone 123 in dieser Richtung, wie durch den Pfeil links dargestellt ist, nach oben und nach unten durch einen Linearantrieb 131, beispielsweise in Form eines Hydraulikzylinders.

Es ist zu erkennen, dass die Zentrierschablone 123 an ihrer Unterseite Führungsöffnungen 126 aufweist, die U-förmig sind und von der Anordnung her genau zu den Rohren 118 passen. Dabei können diese Führungsöffnungen 126 ein Stück breiter sein als die Rohre 118, müssen es aber nicht.

Des weiteren ist an der Zentrierschablone 123 ein streifenartiger Arretierungsschieber 133 vorgesehen, der mittels eines nicht dargestellten Antriebs hin- und herbewegt werden kann, und zwar aus der in Fig. 4 dargestellten Position nach rechts. In der in Fig. 4 dargestellten Stellung befindet er sich in der Öffnungsposition, was bedeutet, dass die Führungsöffnungen 126 nach unten völlig frei sind.

In Fig. 5 ist dargestellt, wie die Zentrierschablone 123 über die Rohre 118 nach unten gefahren worden ist, sodass diese in den Führungsöffnungen 126 verlaufen bzw. sich darin befinden, und zwar sozusagen am oberen Anschlag derselben. Des Weiteren ist der Arretierungsschieber 133 nach rechts bewegt worden in die Arretierungsposition, und zwar um einen geringen Weg von etwa einem halben Rohrdurchmesser. Dabei bewegen sich Arretierungsvorsprünge 135, die auch in Fig. 4 gestrichelt dargestellt sind mit dem Umriss des Arretierungsschiebers 133, im unteren Bereich der Arretierungsöffnungen 134 ein Stück nach rechts unter die Rohre 118. Die Arretierungsöffnungen 134 sind dabei ähnlich wie die Führungsöffnungen 126 U-artig ausgebildet, allerdings breiter. Diese größere Breite wird lediglich durch die Arretierungsvorsprünge 135 links unten beschränkt. So können diese Arretierungsvorsprünge 135 bei nach rechts gefahrenen Arretierungsschieber 133 unter die Rohre 118 fahren und, wie aus Fig. 5 gut ersichtlich ist, verhindern, dass diese nach unten aus den Führungsöffnungen 126 rutschen oder sich überhaupt mehr bewegen als gewünscht ist. Die Rohre 118 werden sozusagen zwischen dem Arretierungsvorsprung 135 links unten und dem oberen sowie rechten Bereich der Führungsöffnungen 126 gehalten.

Ob diese Halterung nun ein festes Einklemmen ist für ein Einführen der Rohre 118 in den nicht dargestellten Träger oder aber sie noch etwas Bewegungsspielraum haben, beispielsweise falls die Rohre 118 in Längsrichtung verschiebbar sein sollen, kann frei gewählt werden und liegt im Rahmen der hier vorliegenden Erfindung. Es ist auch gut vorstellbar, anstelle des hier dargestellten Arretierungsschiebers 133 andere Möglichkeiten vorzusehen, beispielsweise eine von unten herein geschwenkte Leiste, die quer über alle Führungsöffnungen 126 geht, odgl..

Aus den Fig. 4 und 5 ist auch ersichtlich, dass die hier dargestellte Zentrierschablone bei der zweiten Ausführung der Erfindung dadurch, dass sie am selben Schwenkarm 122 vorgesehen ist und dieser auch an demselben Trägerrahmen wie die Rohrhalterung 121 angebracht ist, bis auf die Vertikalposition die stets gleiche Zuordnung zu den Rohren 118 aufweist. Bei über die Rohre 118 geführter Zentrierschablone 123 gemäß Fig. 5 ist, anders als bei den Fig. 1 bis 3, zwar die Zentrierschablöne selbst nicht direkt am Träger angelegt zur genauen Ausrichtung. Allerdings ist sie innerhalb der erfindungsgemäßen Vorrichtung 111 genau festgelegt und somit auch die Rohre 118. Da sich der Träger ebenfalls innerhalb der Vorrichtung 111 in genau vorgegebener Position befindet, kann so ein genaues Einführen erfolgen.

Es ist deutlich zu erkennen, dass bei der zweiten erfindungsgemäßen Ausführung die Zentrierschablone 123 nach dem Einführen der Rohre 118 in den Träger entfernt werden kann bzw. die Rohre 118 freigibt und angehoben wird. Dies macht das anschließende Reinigungsverfahren einfacher. Allerdings ist dazu der weitere Aktor bzw. Antrieb 131 notwendig.

## Patentansprüche

1. Vorrichtung zur Reinigung von Substraten (14) an einem Träger (12), wobei der Träger (12) in seinem Inneren mehrere parallel zueinander verlaufende Längskanäle (16) aufweist, die an der Unterseite des Trägers (12) mittels Öffnungen nach Außen verbunden sind,
**gekennzeichnet durch**
- mehrere längliche parallel zueinander verlaufende Rohre (18a, 18b, 118), die an einer Rohrhalterung (21a, 21b, 121) angeordnet und mit einer Flüssigkeits-Versorgung flüssigkeitsleitend verbunden sind, und
- eine Zentrierschablone (23a, 23b, 123), welche die Rohre (18a, 18b, 118) übergreift und in deren Längsrichtung relativ zu diesen bewegbar ist,
- wobei die Zentrierschablone (23a, 23b, 123) Führungen (26a, 26b, 126) für die Rohre (18a, 18b, 118) aufweist, deren Durchmesser nur geringfügig größer ist als der Außendurchmesser der Rohre, und relativ bewegbar ist zwischen einer Ansetzposition im Endbereich der Rohre weg von der Rohrhalterung und einer Arbeitsposition, die zwischen der Ansetzposition und der Rohrhalterung liegt.

2. Vorrichtung nach Anspruch 1, **dadurch gekennzeichnet, dass** die Zentrierschablone abstehende Zentriervorsprünge (25a, 25b) aufweist, die in vorgegebener Zuordnung an dem Träger bzw. einer zu der Zentrierschablone weisenden Stirnseite angreifen, insbesondere an dafür vorgesehenen Ausnehmungen im Träger, wobei die Zentriervorsprünge in der Ansetzposition über die Enden der Rohre überstehen.

3. Vorrichtung nach Anspruch 1 oder 2, **dadurch gekennzeichnet, dass** die Zentrierschablone sämtliche Rohre der Rohrhalterung aufnimmt bzw. zentriert.

4. Vorrichtung nach einem der vorhergehenden Ansprüche, **dadurch gekennzeichnet, dass** die Zentrierschablone durch eine elastische Kraft oder Federkraft weg von der Rohrhalterung in die Ansetzposition gedrückt ist.

5. Vorrichtung nach einem der vorhergehenden Ansprüche, **dadurch gekennzeichnet, dass** die Zentrierschablone ausschließlich auf den Rohren sitzt bzw. auf diesen geführt ist.

6. Vorrichtung nach einem der Ansprüche 1 bis 4, **dadurch gekennzeichnet, dass** mindestens ein Längsträger an der Rohrhalterung vorgesehen ist und die Zentrierschablone an diesem Längsträger der Rohrhalterung geführt und längsverschiebbar gelagert ist, wobei vorzugsweise außerhalb der Rohre an beiden Seiten ein solcher Längsträger an der Rohrhalterung vorgesehen ist.

7. Vorrichtung nach einem der Ansprüche 1 bis 4, **dadurch gekennzeichnet, dass** die Zentrierschablone mit mindestens einem Führungsstab (28a, 28b) fest verbunden ist bzw. einen solchen aufweist, wobei der Führungsstab in der Rohrhalterung in Längsrichtung der Rohre längsverschiebbar beweglich geführt ist.

8. Vorrichtung nach Anspruch 7, **dadurch gekennzeichnet, dass** eine elastische Federeinrichtung (27) zum Bewegen der Zentrierschablone in die Ansetzposition auf der von den Rohren abgewandten Seite der Rohrhalterung vorgesehen ist und an einem dort befindlichen Ende des Führungsstabs angreift sowie an der Rohrhalterung selbst.

9. Vorrichtung zur Reinigung von Substraten (14) an einem Träger (12), wobei der Träger (12) in seinem Inneren mehrere parallel zueinander laufende Längskanäle (16) aufweist, die an der Unterseite des Trägers (12) mittels Öffnungen nach Außen Verbunden sind, **gekennzeichnet durch**
- mehrere längliche parallel zueinander verlaufende Rohre (18a, 18b, 118), die an einer Rohrhalterung (21 a, 21 b, 121) angeordnet und mit einer Flüssigkeits-Versorgung flüssigkeitsleitend verbunden sind, und
- eine Zentrierschablone (23a, 23b, 123) zum Übergreifen der Rohre zum Einführen in die Längskanäle (16) des Trägers (12),
- wobei die Zentrierschablone (23a, 23b, 123) Führungen (26a, 26b, 126) für die Rohre aufweist und relativ bewegbar ist zwischen einer Ansetzposition im Endbereich der Rohre weg von der Rohrhalterung und einer Parkposition außerhalb der Rohre und entfernt davon.

10. Vorrichtung nach Anspruch 9, **dadurch gekennzeichnet, dass** die Zentrierschablone separat von der Rohrhalterung und den Rohren gehalten ist.

11. Vorrichtung nach Anspruch 9 oder 10, **dadurch gekennzeichnet, dass** die Zentrierschablone unabhängig von den Rohren zwischen der Ansetzposition und der Parkposition bewegbar ist.

12. Vorrichtung nach Anspruch 11, **dadurch gekennzeichnet, dass** die Bewegung zwischen der Ansetzposition und der Parkposition eine lineare Bewegung ist, insbesondere in Richtung senkrecht zu der Längsrichtung der Rohre bzw. einer von den Rohren gebildeten Fläche.

13. Vorrichtung nach einem der Ansprüche 9 bis 12, **dadurch gekennzeichnet, dass** die Parkposition oberhalb der Rohre ist.

14. Vorrichtung nach einem der Ansprüche 9 bis 13, **dadurch gekennzeichnet, dass** die Zentrierschablone mit einer Verfahreinrichtung zum Bewegen zwischen der Park- und der Ansetzposition an einem Trägerrahmen angeordnet ist, an dem auch die Rohrhalterung mit den Rohren angeordnet ist.

15. Vorrichtung nach einem der Ansprüche 9 bis 14, **dadurch gekennzeichnet, dass** die Führungen der Zentrierschablonen nach unten offen sind als Führungsöffnungen (126) zum Übergreifen der Rohre, wobei Arretierungsmittel (134) am unteren Bereich der Führungen vorgesehen sind, die derart ausgebildet sind, dass sie durch Verfahren die Rohre in den Führungen halten, insbesondere durch zumindest teilweises Verschließen der Führungen unterhalb der übergriffenen Rohre.

16. Vorrichtung nach Anspruch 15, **dadurch gekennzeichnet, dass** die Arretierungsmittel sämtlicher Führungen miteinander verbunden sind zum gleichzeitigen Bewegen aller Arretierungsmittel, insbesondere durch einen Aktor gesteuert.

## Claims

1. Device for cleaning substrates (14) on a carrier (12), wherein the carrier (12) has in the interior thereof a plurality of longitudinal passages (16), which run parallel to one another and are connected to the outside at the underside of the carrier (12) by means of openings,
**characterized by**
- a plurality of elongated pipes (18a, 18b, 118) which run parallel to one another and are arranged on a pipe holder (21 a, 21 b, 121) and connected in a fluid-conducting manner to a fluid supply, and
- a centring template (23a, 23b, 123) which encompasses the pipes (18a, 18b, 118) and is movable relative to the pipes in the longitudinal direction thereof,
- wherein the centring template (23a, 23b, 123) has guides (26a, 26b, 126) for the pipes (18a, 18b, 118), the diameter of which guides is only slightly larger than the outside diameter of the pipes, and the centring template is movable in a relative manner between an attachment position in the end region of the pipes away from the pipe holder and a working position lying between the attachment position and the pipe holder.

2. Device according to claim 1, **characterized in that** the centring template has protruding centring projections (25a, 25b) which engage on the carrier, or an end face pointing towards the centring template, in a predetermined relationship, in particular into apertures provided therefor in the carrier, wherein the centring projections project beyond the ends of the pipes in the attachment position.

3. Device according to claim 1 or 2, **characterized in that** the centring template accommodates and/or centres all the pipes of the pipe holder.

4. Device according to any one of the preceding claims, **characterized in that** the centring template is pushed away from the pipe holder into the attachment position by an elastic force or spring force.

5. Device according to any one of the preceding claims, **characterized in that** the centring template sits solely on the pipes or is solely guided thereon.

6. Device according to any one of the claims 1 to 4, **characterized in that** at least one longitudinal member is provided on the pipe holder and the centring template is guided and is mounted in a longitudinally displaceable manner on this longitudinal member of the pipe holder, wherein preferably such a longitudinal member is provided on the pipe holder outside the pipes on both sides.

7. Device according to any one of the claims 1 to 4, **characterized in that** the centring template is fixedly connected to at least one guide rod (28a, 28b) or has such a guide rod, wherein the guide rod is movably guided in the pipe holder in a longitudinally displaceable manner in the longitudinal direction of the pipes.

8. Device according to claim 7, **characterized in that** an elastic spring device (27) for moving the centring template into the attachment position is provided on that side of the pipe holder which faces away from the pipes and acts on an end, located there, of the guide rod and on the pipe holder itself.

9. Device for cleaning substrates (14) on a carrier (12), wherein the carrier (12) has in the interior thereof a plurality of longitudinal passages (16), which run parallel to one another and are connected to the outside at the underside of the carrier (12) by means of openings,
**characterized by**
- a plurality of elongated pipes (18a, 18b, 118) which run parallel to one another and are arranged on a pipe holder (21 a, 21 b, 121) and connected in a fluid-conducting manner to a fluid supply, and
- a centring template (23a, 23b, 123) for encompassing the pipes for inserting the pipes into the longitudinal passages (16) of the carrier (12),
- wherein the centring template (23a, 23b, 123) has guides (26a, 26b, 126) for the pipes and wherein it is movable in a relative manner between an attachment position in the end region of the pipes away from the pipe holder and a parking position outside the pipes and at a distance therefrom.

10. Device according to claim 9, **characterized in that** the centring template is held separately from the pipe holder and the pipes.

11. Device according to claim 9 or 10, **characterized in that** the centring template is movable independently of the pipes between the attachment position and the parking position.

12. Device according to claim 11, **characterized in that** the movement between the attachment position and the parking position is a linear movement, in particular in a direction perpendicular to the longitudinal direction of the pipes or an area formed by the pipes.

13. Device according to any one of the claims 9 to 12, **characterized in that** the parking position is above the pipes.

14. Device according to any one of the claims 9 to 13, **characterized in that** the centring template together with a displacing device for moving between the parking position and the attachment position is arranged on a carrier frame on which the pipe holder with the pipes is arranged.

15. Device according to any one of the claims 9 to 14, **characterized in that** the guides of the centring templates are open at the bottom as guide openings (126) for encompassing the pipes, wherein locking means (134) are provided on the bottom region of the guides, said locking means being designed in such a way that they hold the pipes in the guides by displacement, in particular by at least partly closing the guides below the encompassed pipes.

16. Device according to claim 15, **characterized in that** the locking means of all the guides are connected to one another for the simultaneous movement of all the locking means, in particular controlled by an actuator.

## Revendications

1. Dispositif de nettoyage de substrats (14) sur un support (12), le support (12) comprenant dans son intérieur plusieurs canaux longitudinaux (16) s'étendant parallèlement les uns aux autres, lesquels sont reliés au niveau du côté inférieur du support (12) au moyen d'ouvertures vers l'extérieur,
**caractérisé par**
- plusieurs tubes allongés (18a, 18b, 118) s'étendant parallèlement les uns aux autres, lesquels sont disposés sur un élément de retenue de tubes (21a, 21b, 121) et sont reliés en communication fluidique à une alimentation en liquide, et
- un gabarit de centrage (23a, 23b, 123), lequel chevauche les tubes (18a, 18b, 118) et est déplaçable par rapport à ceux-ci dans leur direction longitudinale,
- le gabarit de centrage (23a, 23b, 123) comprenant des guides (26a, 26b, 126) pour les tubes (18a, 18b, 118), dont le diamètre n'est que légèrement supérieur au diamètre extérieur des tubes, et étant déplaçable relativement entre une position de mise en place dans la région d'extrémité des tubes à l'écart de l'élément de retenue de tubes et une position de travail qui se situe entre la position de mise en place et l'élément de retenue de tubes.

2. Dispositif selon la revendication 1, **caractérisé en ce que** le gabarit de centrage comprend des saillies de centrage (25a, 25b) protubérantes qui viennent en prise de manière associée de façon prédéfinie sur le support ou sur un côté frontal tourné vers le gabarit de centrage, en particulier sur des évidements prévus à cet effet dans le support, les saillies de centrage faisant saillie au-delà des extrémités des tubes dans la position de mise en place.

3. Dispositif selon la revendication 1 ou 2, **caractérisé en ce que** le gabarit de centrage reçoit ou centre tous les tubes de l'élément de retenue de tubes.

4. Dispositif selon l'une quelconque des revendications précédentes, **caractérisé en ce que** le gabarit de centrage est poussé à l'écart de l'élément de retenue de tubes dans la position de mise en place par une force élastique ou une force de ressort.

5. Dispositif selon l'une quelconque des revendications précédentes, **caractérisé en ce que** le gabarit de centrage repose exclusivement sur les tubes ou est guidé exclusivement sur ceux-ci.

6. Dispositif selon l'une quelconque des revendications 1 à 4, **caractérisé en ce qu'**au moins un support longitudinal est prévu sur l'élément de retenue de tubes et le gabarit de centrage est guidé et monté de manière déplaçable longitudinalement sur ce support longitudinal de l'élément de retenue de tubes, un tel support longitudinal étant de préférence prévu sur l'élément de retenue de tubes des deux côtés à l'extérieur des tubes.

7. Dispositif selon l'une quelconque des revendications 1 à 4, **caractérisé en ce que** le gabarit de centrage est relié fixement à au moins une tige de guidage (28a, 28b) ou comprend une telle tige de guidage, la tige de guidage étant guidée de manière mobile dans l'élément de retenue de tubes de manière déplaçable longitudinalement dans la direction longitudinale des tubes.

8. Dispositif selon la revendication 7, **caractérisé en ce qu'**un dispositif de ressort élastique (27) pour déplacer le gabarit de centrage dans la position de mise en place est prévu sur le côté de l'élément de retenue de tubes opposé aux tubes, et vient en prise avec une extrémité s'y trouvant de la tige de guidage ainsi qu'avec l'élément de retenue de tubes lui-même.

9. Dispositif de nettoyage de substrats (14) sur un support (12), le support (12) comprenant dans son intérieur plusieurs canaux longitudinaux (16) s'étendant parallèlement les uns aux autres, lesquels sont reliés au niveau du côté inférieur du support (12) au moyen d'ouvertures vers l'extérieur,
**caractérisé par**
- plusieurs tubes allongés (18a, 18b, 118) s'étendant parallèlement les uns aux autres, lesquels sont disposés sur un élément de retenue de tubes (21a, 21b, 121) et sont reliés en communication fluidique à une alimentation en liquide, et
- un gabarit de centrage (23a, 23b, 123) pour chevaucher les tubes en vue de l'insertion dans les canaux longitudinaux (16) du support (12),
- le gabarit de centrage (23a, 23b, 123) comprenant des guides (26a, 26b, 126) pour les tubes et étant déplaçable relativement entre une position de mise en place dans la région d'extrémité des tubes à l'écart de l'élément de retenue de tubes et une position de repos à l'extérieur des tubes et éloignée de ceux-ci.

10. Dispositif selon la revendication 9, **caractérisé en ce que** le gabarit de centrage est retenu de manière séparée de l'élément de retenue de tubes et des tubes.

11. Dispositif selon la revendication 9 ou 10, **caractérisé en ce que** le gabarit de centrage est déplaçable indépendamment des tubes entre la position de mise en place et la position de repos.

12. Dispositif selon la revendication 11, **caractérisé en ce que** le déplacement entre la position de mise en place et la position de repos est un déplacement linéaire, en particulier dans la direction perpendiculaire à l'axe longitudinal des tubes ou à une surface formée par les tubes.

13. Dispositif selon l'une quelconque des revendications 9 à 12, **caractérisé en ce que** la position de repos est située au-dessus des tubes.

14. Dispositif selon l'une quelconque des revendications 9 à 13, **caractérisé en ce que** le gabarit de centrage est disposé, conjointement avec un dispositif de déplacement pour le déplacement entre la position de repos et la position de mise en place, sur un cadre de support sur lequel est également disposé l'élément de retenue de tubes pourvu des tubes.

15. Dispositif selon l'une quelconque des revendications 9 à 14, **caractérisé en ce que** les guides des gabarits de centrage sont ouverts vers le bas en tant qu'ouvertures de guidage (126) pour chevaucher les tubes, des moyens de blocage (134) étant prévus sur la région inférieure des guides, lesquels moyens de blocage sont réalisés de telle sorte qu'ils retiennent les tubes dans les guides par déplacement, en particulier par fermeture au moins partielle des guides en dessous des tubes chevauchés.

16. Dispositif selon la revendication 15, **caractérisé en ce que** les moyens de blocage de tous les guides sont reliés les uns aux autres pour déplacer simultanément tous les moyens de blocage, en particulier de manière commandée par un actionneur.
